# EUROPEAN PATENT APPLICATION

(11) **EP 2 642 835 A2**
(43) Date of publication of application: **25.09.2013**
(21) Application number: 12170273.2
(22) Date of filing: 31.05.2012
(51) Int. Cl.: H05K 1/02

(54) **Wiring board device, luminaire, and manufacturing method of the wiring board device**

(30) Priority: 23.03.2012 JP 2012068333
(71) Applicant: Toshiba Lighting & Technology Corporation, Yokosuka-shi Kanagawa 237-8510 (JP)
(72) Inventor: Tanaka, Hirotaka, Kanagawa, 237-8510 (JP); Nishimura, Kiyoshi, Kanagawa, 237-8510 (JP); Watanabe, Miho, Kanagawa, 237-8510 (JP); Betsuda, Nobuhiko, Kanagawa, 237-8510 (JP); Honma, Takuya, Kanagawa, 237-8510 (JP)
(74) Representative: Bokinge, Ole

(57) **Abstract**

According to one embodiment, a wiring board device is provided in which even if the temperature of a ceramic board becomes high, the influence on a connector can be reduced and the occurrence of defects due to heat can be prevented. The wiring board device includes a common member. The ceramic board and the connector are placed on the common member. A wiring pattern of the ceramic board and the connector are electrically connected by wiring.

## Description

### FIELD

Embodiments described herein relate generally to a wiring board device including a connector, a luminaire and a manufacturing method of the wiring board device.

### BACKGROUND

Hitherto, for example, in an LED module used in a luminaire, a wiring board device in which a wiring pattern is formed on one surface of a board is used. An LED element is electrically connected to the wiring pattern of the board, and a connector for power feeding is soldered thereto. A cable from a lighting device is connected to the connector. Then, lighting power from the lighting device is supplied to the LED element through the cable, the connector and the wiring pattern, and the LED element is turned on.

Besides, in the LED module, the output is increased, and the board is required to have high heat resistance and high heat radiation property as the output increases. In order to satisfy this request, a ceramic board is often used. Also in the ceramic board, similarly to a general printed wiring board, a wiring pattern is generally formed on one surface of the ceramic board by printing. Accordingly, a connector is also soldered and placed on the wiring pattern of the ceramic board.

When the ceramic board is used, even if the temperature of the ceramic board becomes high with the increase of output and by heat generated by the LED element, since the ceramic board has high heat resistance, there is no problem. However, since the heat is filled in the ceramic board and the temperature of the ceramic board is liable to become high, the temperature of the solder connecting the connector to the ceramic board is also liable to become high.

Since thermal expansion coefficients of a resin portion of the connector, a metal portion of the connector and the ceramic board are different from each other between the connector and the ceramic, stress is applied to the solder due to the difference between the thermal expansion coefficients, and a crack becomes liable to occur in the solder. When the crack occurs in the solder, there is a problem that defective connection of the connector occurs.

Exemplary embodiments described herein provide a wiring board device, a luminaire and a manufacturing method of the wiring board device, in which even if the temperature of a ceramic board becomes high, influence on a connector can be reduced and the occurrence of defects due to heat can be prevented.

### BRIEF DESCRIPTION OF THE DRAWINGS

FIG. 1 is a sectional view of a wiring board device of an embodiment.
FIG. 2 is a front view of the wiring board device.
FIG. 3 is a sectional view of the wiring board device.
FIGS. 4 (a) to 4(c) are sectional views showing a manufacturing method of the wiring board device in order.
FIG. 5 is a perspective view of a luminaire using the wiring board device.

### DETAILED DESCRIPTION

In general, according to one embodiment, a wiring board device includes a common member. A ceramic board and a connector are placed on the common member. A wiring pattern of the ceramic board and the connector are electrically connected by wiring.

According to this structure, since the ceramic board and the connector are placed on the common member, even if the temperature of the ceramic board becomes high, influence on the connector can be reduced, and the occurrence of defects due to heat can be prevented.

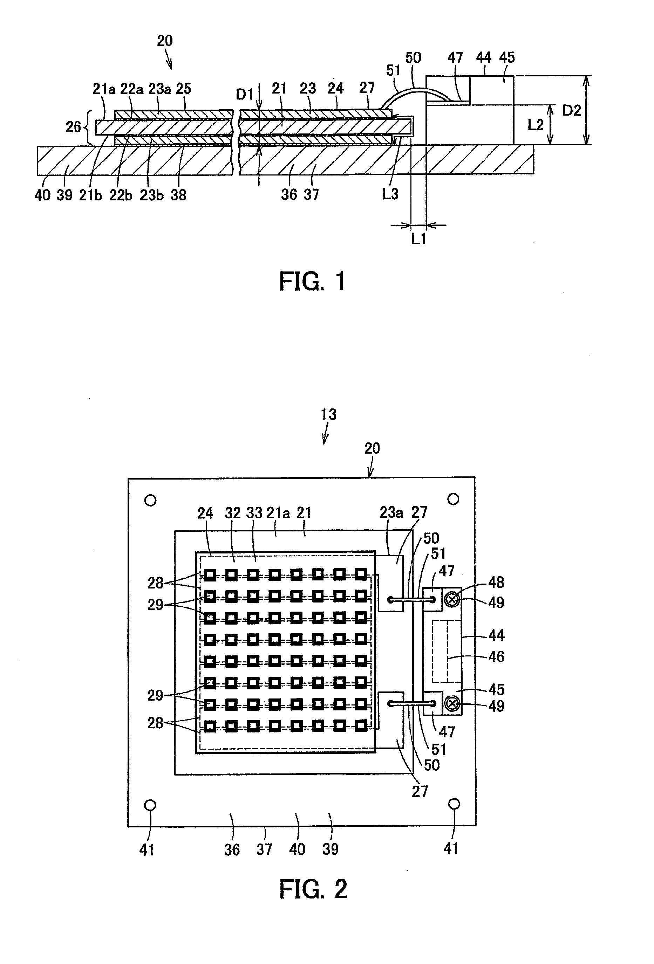

Hereinafter, an embodiment will be described with reference to FIG. 1 to FIG. 5.

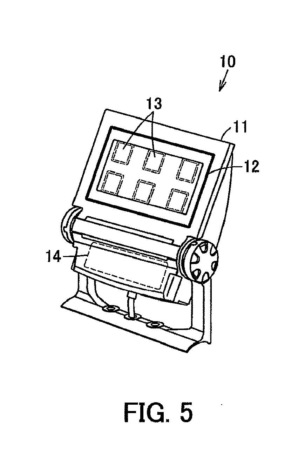

FIG. 5 shows a luminaire 10. The luminaire 10 is, for example, a floodlight used for lighting-up. The luminaire 10 includes an equipment main body 11, and a floodlight window 12 is provided in the equipment main body 11. Plural light-emitting modules 13 facing the floodlight window 12 are housed in the equipment main body 11. A lighting device 14 to supply lighting power to the light-emitting module 13 is housed at a lower part in the equipment main body 11. The lighting device 14 supplies the lighting power to the plural light-emitting modules 13, so that the plural light-emitting modules 13 are turned on, and light is emitted from the floodlight window 12.

FIG. 1 and FIG. 2 show the light-emitting module 13. The light-emitting module 13 includes a wiring board device 20.

The wiring board device 20 includes a square ceramic board 21. A front side of the ceramic board 21 is a first surface 21a, and a back side thereof is a second surface 21b. A first electrode layer 22a is formed on the first surface 21a, and a first copper plated layer 23a as a copper plated layer 23 is formed on the first electrode layer 22a. A wiring pattern 24 having a specific shape is formed of the first electrode layer 22a and the first copper plated layer 23a. On the other hand, a second electrode layer 22b is formed on substantially the whole area of the second surface 21b, and a second copper plated layer 23b is formed on the second electrode layer 22b. Further, metal plated layers 25 to protect the copper plated layers 23a and 23b are formed on the surfaces of the copper plated layers 23a and 23b.

The electrode layers 22a and 22b are formed by sputtering of a metal such as titanium. The copper plated layers 23a and 23b are formed in such a manner that a current is applied to the electrode layers 22a and 22b in a state where the ceramic board 21 is immersed in a copper plating solution of a plating device and copper plating is applied onto the electrode layers 22a and 22b. Besides, the metal plated layer 25 is formed of, for example, nickel/gold plating or nickel/lead/ gold plating. A DPC (Direct Plated Copper) board 26 is formed of the ceramic board 21, the electrode layers 22a and 22b, the copper plated layers 23a and 23b, and the metal plated layer 25.

The first electrode layer 22a and the second electrode layer 22b are formed to have the same thickness, and the first copper plated layer 23a and the second copper plated layer 23b are formed to have the same thickness. The thickness of the first electrode layer 22a is about 1 µm, the minimum width of the first copper plated layer 23a (a wiring pattern 24 through which current flows) is 50 to 75 µm, and the thickness thereof is 35 to 100 µm (preferably, 50 to 75 µm). Incidentally, when the wiring pattern is formed by printing, the thickness of the wiring pattern is at most about 10 µm.

As shown in FIG. 2, the wiring pattern 24 includes a positive and negative pair of electrode parts 27 to receive lighting power from the outside, and plural wiring parts 28 are formed in parallel between the pair of electrode parts 27. Plural LED elements 29 are mounted on the adjacent wiring parts 28.

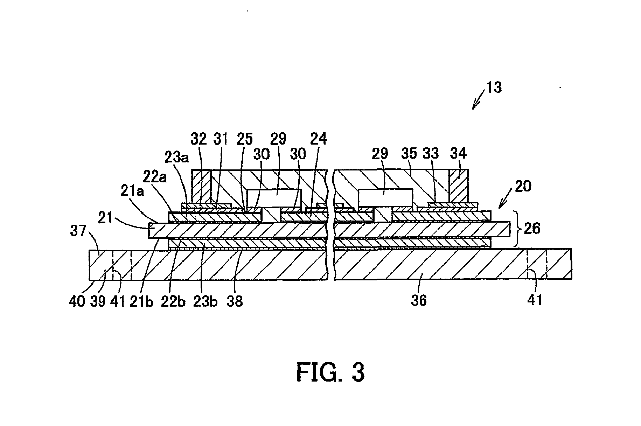

As shown in FIG. 3, the plural LED elements 29 are of a type, such as a flip chip type, in which a pair of electrodes are provided on the back side. The pairs of electrodes of the plural LED elements 29 are electrically connected to the first copper plated layer 23a by solder die bond layers 30. Incidentally, the LED element may be such that an electrode is provided on the front surface side as in a face-up type, and the electrode of the LED element and the wiring pattern 24 are connected by wire bonding.

A white organic resist layer 31 containing epoxy resin as a main component is formed on the first surface 21a side including the first copper plated layer 23a. A white inorganic resist ink layer 32 containing ceramic as a main component is formed on the organic resist layer 31. The surfaces of the organic resist layer 31 and the inorganic resist ink layer 32 are formed as a reflecting surface 33 to reflect light emitted from the plural LED elements 29.

Besides, an annular reflecting frame 34 is formed on the first surface 21a side so as to surround a mount area of the plural LED elements 29. A sealing resin 35 to seal the plural LED elements 29 is filled inside the reflecting frame 34. The sealing resin 35 contains a phosphor which is excited by the light generated by the plural LED elements 29. For example, when the light-emitting module 13 emits white light, the LED element 29 emitting blue light and the phosphor mainly emitting yellow light are used. The blue light generated by the LED element 29 is mixed with the yellow light generated by the phosphor which is excited by the blue light generated by the LED element 29, and white light is emitted from the surface of the sealing resin 35. Incidentally, the LED element 29 and the phosphor, which emit lights of colors corresponding to the color of irradiated light, are used.

Besides, the light-emitting module 13 is placed on one surface of a heat spreader 37 as a common member 36. That is, the second copper plated layer 23b of the DPC board 26 is fixed to the one surface of the heat spreader 37 by a solder layer 38 and is thermally connected thereto. The heat spreader 37 includes a copper plate 39 having a thickness of 0.1 to 3 mm, and a metal plated layer 40 of, for example, nickel is formed on the whole surface of the copper plate 39. Attachment holes 41 for fixing to a heat radiation part of the luminaire 10 using screws are formed at four corners of the heat spreader 37.

Besides, as shown in FIG. 1 and FIG. 2, a connector 44 is placed on the one surface of the heat spreader 37 adjacent to the light-emitting module 13. The connector 44 includes a case 45 made of a synthetic resin having insulating properties, and a connector terminal 46 arranged in the case 45. A pair of positive and negative terminal parts 47 electrically connected to the connector terminal 46 are provided outside the case 45. The connector 44 is fixed to the heat spreader 37 by a fixing unit 48 in an insulated state. A screw 49 to be screwed into the heat spreader 37 through the case 45 is used as the fixing unit 48. Incidentally, as the fixing unit 48, an adhesive to bond the case 45 to the heat spreader 37 may be used in stead of the screw 49, and any fixing unit other than solder may be used.

The respective terminal parts 47 and the respective electrode parts 27 of the light-emitting module 13 are electrically connected to each other by wirings 50. A wire 51, such as a circular wire having a section with a diameter of 300 to 500 µm or a ribbon wire having a width of 0.1 to 0.2 mm and a thickness of 100 µm, is used as each of the wirings 50. The wire 51 is ultrasonically welded to the terminal part 47 and the electrode part 27 by wire bonding, and the electrical connection is made. Aluminum having high reflectivity is used as the material of the wire 51.

A thickness D1 of the DPC board 26 including the ceramic board 21 is about 1 mm, and a thickness D2 of the connector 44 is about 2 to 5 mm. The thickness D1 of the DPC board 26 (the ceramic board 21) is thinner than the thickness D2 of the connector 44.

An interval L1 of, for example, about 1.2 mm is provided between the ceramic board 21 and the connector 44. The interval L1 is smaller than a creeping distance L2 along the surface of the connector 44 (the case 45) between the terminal part 47 and the heat spreader 37.

Besides, a creeping distance L3 along the surface of the ceramic board 21 between the electrode part 27 of the wiring pattern 24 and the heat spreader 37 is equal to or larger than the creeping distance L2 along the surface of the connector 44 (the case 45) between the terminal part 47 and the heat spreader 37, and the relation of L3 ≥ L2 is established.

Besides, in order to ensure insulation between the wire 51 and the heat spreader 37, a spatial distance of 4 mm or more is provided between the wire 51 and the heat spreader 37.

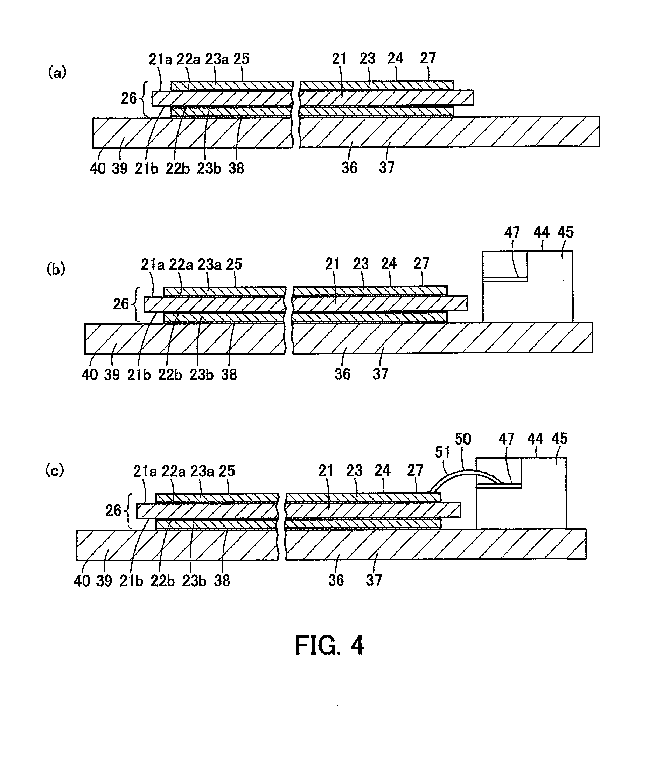

Next, a manufacturing method of the wiring board device 20 will be described with reference to FIGS. 4(a) to 4(c).

As shown in FIG. 4 (a), the DPC board 26 is placed on one surface of the heat spreader 37. That is, the second copper plated layer 23b of the DPC board 26 is fixed to the one surface of the heat spreader 37 by the solder layer 38 and is thermally connected thereto.

As shown in FIG. 4(b), the connector 44 is arranged on the one surface of the heat spreader 37, the screws 49 are threaded into the heat spreader 37 through the case 45, and the connector 44 is fixed to the one surface of the heat spreader 37.

As shown in FIG. 4(c), the wires 51 are ultrasonically welded to the terminal parts 47 of the connector 44 and the respective electrode parts 27 of the DPC board 26, and the electrical connection is made.

Incidentally, when the DPC board 26 is placed on the one surface of the heat spreader 37, the light-emitting module 13 may be assembled in which the LED elements 29 are already mounted on the DPC board 26. Alternatively, after the DPC board 26 is placed on the one surface of the heat spreader 37, the light-emitting module 13 may be assembled by mounting the LED elements 29 on the DPC board 26.

Besides, as shown in FIG. 5, the plural light-emitting modules 13 are disposed in the equipment main body 11. In this case, screws are threaded into the attachment holes 41 of the heat spreader 37 to fix the heat spreader to the heat radiation part of the equipment main body 11, and the heat spreader 37 is thermally connected to the heat radiation part of the equipment main body 11. Besides, a cable from the lighting device 14 is connector-connected to the connector 44 of the light-emitting module 13.

The lighting device 14 supplies lighting power to the plural light-emitting modules 13, so that the lighting power flows through the plural LED elements 29 through the wiring patterns 24 of the respective light-emitting modules 13. Thus, the plural light-emitting modules 13 are turned on, and the lights from the plural light-emitting modules 13 are emitted from the floodlight window 12.

The heat generated in the plural LED elements 29 at the time of lighting of the light-emitting modules 13 is efficiently conducted to the first copper plated layer 23a, the ceramic board 21, the second copper plated layer 23b and the heat spreader 37. The heat is further efficiently conducted from the heat spreader 37 to the heat radiation part of the equipment main body 11, and is radiated from the heat radiation part of the equipment main body 11.

In this embodiment, since the ceramic board 21 and the connector 44 are placed on the common member 36, even if the temperature of the ceramic board 21 becomes high, the influence on the connector 44 can be reduced, and the occurrence of defects due to the heat can be prevented.

Besides, since the common member 36 is the heat spreader 37, the heat is efficiently conducted from the ceramic board 21 to the heat spreader 37 and can be radiated. Thus, the temperature rise of the ceramic board 21 can be reduced.

Besides, since the connector 44 is fixed to the common member 36 by the fixing unit 48 in the insulated state, that is, since the connector is fixed without using solder, defects caused by the use of solder and by the influence of heat can be prevented.

Besides, since the wires 51 as the wirings 50 are welded to the electrode parts 27 of the wiring pattern 24 and the terminal parts 47 of the connector 44, the mechanical bonding strength is high, the electrical connection becomes stable, and a large current can be made to flow. Thus, in light-emitting module 13, the output can be increased.

Further, since aluminum having high reflectivity is used as the material of the wire 51, the light emitted from the LED element 29 is efficiently reflected, and the light extraction efficiency from the light-emitting module 13 can be improved.

Besides, since the DPC board 26 is used in which the copper plated layer (first copper plated layer) 23a is formed on the ceramic board 21, and the wiring pattern 24 is formed of the copper plated layer (first copper plated layer) 23a, a large current can be made to flow through the wiring pattern 24. Thus, in the light-emitting module 13, the output can be increased.

Besides, although the thickness D1 of the ceramic board 21 (the DPC board 26) is thinner than the thickness D2 of the connector 44, since the interval L1 exists between the ceramic board 21 (the DPC board 26) and the connector 44, in the light-emitting module 13, it can be reduced that the light emitted from the LED element 29 on the ceramic board 21 (the DPC board 26) is blocked by the connector 44.

Further, insulation properties can be ensured by a spatial distance smaller than a creeping distance. From this, the interval L1 as the spatial distance between the ceramic board 21 and the connector 44 can be made smaller than the creeping distance L2 along the surface of the connector 44 between the terminal part 47 and the common member 36. Thus, while the insulation properties are ensured, the distance between the ceramic board 21 and the connector 44 is made small, and an increase in size can be prevented.

The creeping distance L3 along the surface of the ceramic board 21 between the wiring pattern 24 and the common member 36 is equal to or larger than the creeping distance L2 along the surface of the connector 44 between the terminal part 47 and the common member 36, and the relation of L3 ≥ L2 is established. Accordingly, the interval L1 as the spatial distance between the ceramic board 21 and the connector 44 can be made small. Thus, the ceramic board 21 and the connector 44 are arranged to be close to each other while keeping the insulation properties, so that miniaturization can be performed.

Incidentally, the common member 36 is not limited to the heat spreader 37, and another heat radiation member such as, for example, a heat sink may be adopted.

Besides, the wiring board device 20 is not limited to the wiring board device for mounting the LED elements 29, and the wiring board device 20 can be applied to a wiring board device for mounting an integrated circuit and the like, or a wiring board device for mounting electrical parts of a power supply device.

While certain embodiments have been described, these embodiments have been presented by way of example only, and are not intended to limit the scope of the inventions. Indeed, the novel embodiments described herein may be embodied in a variety of other forms; furthermore, various omissions, substitutions, and changes in the form of the embodiments described herein may be made without departing from the spirit of the inventions. The accompanying claims and their equivalents are intended to cover such forms or modifications as would fall within the scope and spirit of the inventions.

## Claims

1. A wiring board device (20) comprising:
a common member (36);
a ceramic board (21) having a wiring pattern (24) and placed on the common member (36);
a connector (44) placed on the common member (36); and
a wiring (50) to electrically connect the wiring pattern (24) and the connector (44).

2. The device (20) of claim 1, wherein the common member (36) is a heat spreader (37).

3. The device (20) of claim 1 or 2, wherein the wiring (50) is welded to the wiring pattern (24).

4. The device (20) of any one of claims 1 to 3, wherein a thickness of the ceramic board (21) is thinner than a thickness of the connector (44), an interval exists between the ceramic board (21) and the connector (44),
the connector (44) includes a terminal part (47) to which the wiring (50) is connected, and
an interval (L1) between the ceramic board (21) and the connector (44) is smaller than a creeping distance (L2) along a surface of the connector (44) between the terminal part (47) and the common member (36).

5. The device (20) of any one of claims 1 to 3, wherein the connector (44) includes a terminal part (47) to which the wiring (50) is connected, and
a creeping distance (L3) along a surface of the ceramic board (21) between the wiring pattern (24) and the common member (36) is equal to or larger than a creeping distance (L2) along a surface of the connector (44) between the terminal part (47) and the common member (36).

6. The device (20) of any one of claims 1 to 5, further comprising an LED element (29) connected to the wiring pattern (24).

7. A luminaire (10) comprising:
an equipment main body (11); and
the wiring board device (20) of claim 6 disposed on the equipment main body (11).

8. A manufacturing method of a wiring board device (20), comprising steps of:
placing a ceramic board (21) having a wiring pattern (24) and a connector (44) on a common member (36); and
electrically connecting the wiring pattern (24) to the connector (44) through a wiring (50).

9. The method of claim 8, wherein a heat spreader (37) is used as the common member (36).

10. The method of claim 8 or 9, wherein the wiring (50) is connected to the wiring pattern (24) by welding in the connecting step.

11. The method of any one of claims 8 to 10, wherein the ceramic board (21) and the connector (44) are placed while an interval is provided between the ceramic board (21) and the connector (44) in the placing step.

12. The method of claim 11, wherein
the connector (44) includes a terminal part (47) to which the wiring (50) is connected, and
in the placing step, an interval (L1) between the ceramic board (21) and the connector (44) is made smaller than a creeping distance (L2) of the connector (44) between the terminal part (47) and the common member (36).

13. The method of claim 11, wherein
the connector (44) includes a terminal part (47) to which the wiring (50) is connected, and
in the placing step, a creeping distance (L3) of the ceramic board (21) between the wiring pattern (24) and the common member (36) is made equal to or larger than a creeping distance (L2) of the connector (44) between the terminal part (47) and the common member (36).
